# EUROPÄISCHE PATENTSCHRIFT

(11) **EP 3 582 376 B1**
(45) Veröffentlichungstag und Bekanntmachung des Hinweises auf die Patenterteilung: **07.04.2021**
(21) Anmeldenummer: 19174621.3
(22) Anmeldetag: 15.05.2019
(51) Int. Cl.: H02K 49/10, H02K 41/03, H02P 25/064, H02N 15/00, H02K 16/02, H01L 21/677, H01F 7/02, B65G 54/02, H02P 6/00, B65G 35/00

(54) **BEFÖRDERUNGSVORRICHTUNG MIT SICHERHEITSFUNKTION**
CONVEYOR DEVICE WITH SAFETY FEATURE
DISPOSITIF DE TRANSPORT À FONCTION DE SÉCURITÉ

(30) Priorität: 13.06.2018 DE 102018209401
(43) Veröffentlichungstag der Anmeldung: 18.12.2019
(73) Patentinhaber: Robert Bosch GmbH, 70442 Stuttgart (DE)
(72) Erfinder: Frangen, Joachim, 74081 Heilbronn (DE)

(56) Entgegenhaltungen:
- US-A1- 2006 214 756
- US-A1- 2008 038 020
- US-A1- 2018 056 810

## Beschreibung

Die Erfindung betrifft eine Beförderungsvorrichtung gemäß Anspruch 1 und 2, mit der es möglich ist, wenigstens einen Transportkörper allein durch Magnetkräfte in der Schwebe zu halten und diesen kontrolliert zu bewegen. Weiter betrifft die Erfindung ein Verfahren zum Betrieb einer derartigen Beförderungsvorrichtung gemäß Anspruch 8.

Aus der WO 2015/017 933 A1 ist eine entsprechende Beförderungsvorrichtung bekannt, bei welcher die Magnetkräfte mittels Elektromagneten erzeugt werden. Dies verursacht hohe Energieverluste. Weiter ist es sehr aufwändig, die vorgeschriebene Betriebssicherheit der Bewegungsvorrichtung herbeizuführen. Diese gebietet es, dass sich die Transportkörper bei Stromausfall von selbst in eine sichere Stellung bewegen. Bei Überkopfbetrieb dürfen die Transportkörper insbesondere nicht der Wirkung der Schwerkraft folgend herabfallen. Aus der DE 10 2014 225 171 A1 ist ein entsprechendes, aufwändiges Sicherungssystem bekannt.

In der deutschen Patentanmeldung mit dem Aktenzeichen 102016224951.7 hat die Anmelderin eine vollkommen neuartige Beförderungsvorrichtung beschrieben, mit der es möglich ist, die von der WO 2015/017 933 A1 bekannte Funktion allein durch Verwendung von Permanentmagneten zu erzielen. Dadurch entsteht weit weniger Abwärme, wobei gleichzeitig weitaus größere Lasten in der Schwebe gehalten werden können.

US 2008/038020 A1 betrifft eine Transportvorrichtung, bei der ein schienengeführtes Trägerelement mittels am Trägerelement fest angebrachter Magneten und an einer Basis beweglich angebrachter Magneten bewegt werden kann. US 2006/214756 A1 offenbart die Möglichkeit, einen Gegenstand mittels einer Orientierungsänderung eines Magneten anzuheben oder zu bewegen. US 2018/056810 A1 betrifft eine Transportvorrichtung, bei der ein schienengeführtes Trägerelement durch Magnetkräfte bewegt wird.

Ein Vorteil der vorliegenden Erfindung besteht darin, dass die vorgeschriebene Betriebssicherheit mit besonders geringem Aufwand erreicht werden kann. Weiter kann der wenigstens eine Transportkörper allein durch permanentmagnetische Kräfte in der Schwebe gehalten werden, wobei die jeweilige Position relativ zum Stator in sechs Freiheitsgraden verstellbar ist und zwar weitgehend beliebig. Trotz der ausschließlichen Verwendung von Permanentmagneten ist es entgegen dem Earnshaw-Theorem möglich, die Transportkörper stabil in der Schwebe zu halten.

Gemäß den beiden selbständigen Ansprüchen 1 und 2 unterscheidet sich die erfindungsgemäße Beförderungseinrichtung von der Beförderungseinrichtung gemäß der DE102016224951.7 dadurch, dass eine Rast- und/oder eine Reibkraft des Stellelements im stromlosen Zustand so klein gewählt ist, dass sich das Stellelement im stromlosen Zustand unter dem Einfluss der magnetischen Kopplung zwischen den Stationärmagneten und den Stellmagneten selbsttätig in eine stabile Stellung bewegt.

In der genannten stabilen Stellung stehen, den Gesetzen der Physik folgend, magnetische Nord-Pole am Stator magnetischen Süd-Polen am wenigstens einen Transportkörper gegenüber oder umgekehrt. Daraus resultieren starke permanentmagnetische Anziehungskräfte zwischen dem wenigstens einen Transportkörper und dem Stator, so dass der wenigstens eine Transportkörper sehr stark vom Stator angezogen und dort reibschlüssig gehalten wird. Er kann sich somit nicht mehr bewegen und ist dementsprechend in einer sicheren Stellung.

Bei den Stellelementen handelt es sich vorzugsweise um Elektromotoren. Diese weisen im stromlosen Zustand oft ein sogenanntes Rastmoment auf, welches von permanent- und/oder ferromagnetischen Kräften im Elektromotor selbst bewirkt wird. Insbesondere dieses Rastmoment wird im Rahmen der Erfindung klein gewählt.

Die Stellelemente haben vorzugsweise jeweils einen einzigen Bewegungsfreiheitsgrad, insbesondere einen endlosen Drehfreiheitsgrad. Die Stellelemente sind vorzugsweise mit einer Drehlageregelung ausgestattet. Die Drehachsen aller Stellelemente sind vorzugsweise im Wesentlichen parallel ausgerichtet, wobei sie höchst vorzugsweise im Wesentlichen senkrecht zu einer ebenen, dem wenigstens einen Transportkörper zugewandten Beförderungsfläche des Stators ausgerichtet sind. Die Stellmagnete und/oder die Stationärmagnete sind vorzugsweise in der Art eines Halbach-Arrays angeordnet, um mit einer kleinen Materialmenge eine große Magnetkraft zu erzeugen.

Die Beförderungsvorrichtung umfasst vorzugsweise eine Positionsbestimmungseinheit, welche dazu eingerichtet ist, eine relative Position und/oder Orientierung des wenigstens einen Transportkörpers relativ zum Stator zu messen. Vorzugsweise ist die Position und die Orientierung eines jeden Transportkörpers in sechs Freiheitsgraden ermittelbar. Die Positionsbestimmungseinheit kann beispielswese gemäß der US 6 615 155 B2 ausgebildet sein. Wenigstens einem Transportkörper, vorzugsweise allen Transportkörpern, kann eine Positionsregelung zugeordnet sein, deren Ist-Größe von der durch die Positionsbestimmungseinheit gemessenen Positionen bzw. Orientierungen gebildet wird, wobei deren Stellgröße durch die Stellungen der Stellelemente gebildet wird.

Es versteht sich, dass die genannte magnetische Kopplung bei den Stellmagneten, die sich im Bereich eines zugeordneten Transportkörpers befinden, besonders stark ist, während weiter vom Transportkörper entfernte Stellmagnete eine weitaus geringere magnetische Kopplung aufweisen.

Die Stellmagnete und/oder die Stationärmagnete sind Permanentmagnete, höchst vorzugsweise Neodym-Eisen-Bor-Magnete, die ein besonders starkes Magnetfeld aufweisen. Soweit im Rahmen der vorliegenden Anmeldung von mehreren Stationärmagneten oder mehreren Stellmagneten die Rede ist, sollen hierdurch auch einstückige Permanentmagnetanordnungen erfasst sein, die mehrere magnetische Dipole bilden. Diese Permanentmagnetanordnungen können beispielsweise im 3D-Druckverfahren hergestellt werden, wobei der entsprechende Kunststoff ein Bindemittel für permanentmagnetische Partikel bildet.

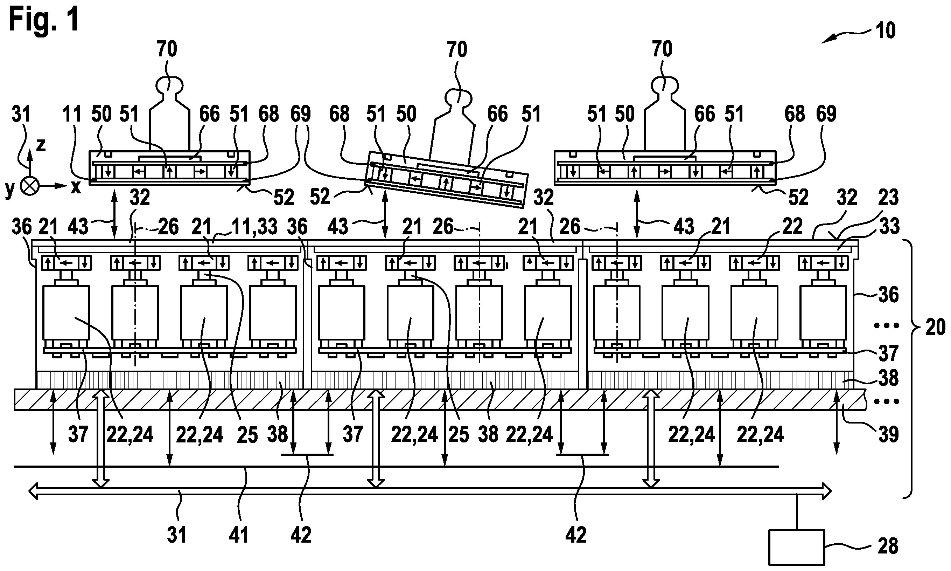

Der Klarheit wegen ist die vorliegende Erfindung in zwei selbständigen Ansprüchen 1 und 2 beansprucht. Bei der praktikableren Variante gemäß Anspruch 1, die in Fig. 1 dargestellt ist, sind die Stellmagnete am Stator angeordnet, wobei die Stationärmagnete am wenigstens einen Transportkörper angeordnet sind. Bei der ebenfalls denkbaren Variante gemäß Anspruch 2 ist es umgekehrt. Es versteht sich, dass auch beliebige Mischformen vom Schutz erfasst sein sollen.

In den abhängigen Ansprüchen sind vorteilhafte Weiterbildungen und Verbesserungen der Erfindung angegeben.

Es kann vorgesehen sein, dass das Stellelement einen Elektromotor umfasst, welcher als Synchronmotor mit einem permanentmagnetischen Läufer oder als Asynchronmotor mit einem Kurzschlussläufer ausgebildet ist. Die genannten Elektromotoren haben im stromlosen Zustand praktisch kein Rastmoment. Der genannte Synchronmotor wird auch als bürstenloser Gleichstrommotor bezeichnet.

Es kann vorgesehen sein, dass eine Antriebswelle des Elektromotors fest mit dem zugeordneten Stellmagneten verbunden ist. Der Elektromotor und der zugeordnete Stellmagnet stehen somit nicht über ein Zahnradgetriebe in Drehantriebsverbindung. Ein Zahnradgetriebe kann hohe Reibung verursachen oder im Extremfall selbsthemmend sein. Dies würde der erfindungsgemäßen Selbstausrichtung der Stellmagnete zuwiderlaufen.

Es kann vorgesehen sein, dass der wenigstens eine Transportkörper und/oder der Stator jeweils einen Energiespeicher aufweist, wobei die Beförderungsvorrichtung so eingerichtet ist, dass sie die für einen Weiterbetrieb erforderliche Energie aus dem Energiespeicher bzw. den Energiespeichern entnimmt, wenn die Energieversorgung von außen her ausfällt. Der Energiespeicher ist vorzugsweise ein elektrischer Energiespeicher, der insbesondere einen Akkumulator und/oder einen Kondensator umfasst. Bei der äußeren Energieversorgung handelt es sich vorzugsweise um eine elektrische Energieversorgung. Es ist darauf hinzuweisen, dass das erfindungsgemäße Grundprinzip auch ohne die Energiespeicher die gewünschte Betriebssicherheit erreicht. Mit den Energiespeichern kann jedoch eine weitere Verbesserung der Betriebssicherheit erzielt werden.

Es kann vorgesehen sein, dass der Stator eine geschlossene Beförderungsfläche aufweist, welche zwischen den Stellmagneten und dem wenigstens einen Transportkörper angeordnet ist. Dementsprechend sind die Stellmagnete vor dem Zugriff durch den Benutzer und vor dem Eindringen von Fremdkörpern geschützt. Die Beförderungsfläche definiert weiter einen Mindestabstand zwischen den Stellmagneten und den Stationärmagneten, der nicht unterschreitbar ist. In der Folge werden sehr hohe Magnetkräfte vermieden, die eine kontrollierte Bewegung des wenigstens einen Transportkörpers beeinträchtigen würden, weil das Drehmoment der Elektromotoren nicht ausreichen würde, um derart hohe Magnetkräfte zu überwinden. Die Beförderungsfläche ist vorzugsweise eben ausgebildet, wobei andere Formen ebenfalls denkbar sind. Sie wird vorzugsweise von wenigstens einer gesonderten Deckplatte gebildet.

Es kann vorgesehen sein, dass die Beförderungsvorrichtung dazu eingerichtet ist, den zumindest einen Transportkörper durch eine kontrollierte Positionierung und/oder Orientierung der mehreren Stellmagneten mittels der Stellelemente relativ zum Stator zu befördern. In diesem Zusammenhang ist insbesondere auf die unten beschriebene Positionsregelung des wenigstens einen Transportkörpers zu verweisen.

Schutz wird außerdem für ein Verfahren gemäß Anspruch 8 zum Betrieb einer erfindungsgemäßen Beförderungseinrichtung nach einem der Ansprüche 1 bis 7. Es kann vorgesehen sein, dass die Energieversorgung von außen her auf einen Ausfall hin überwacht wird, wobei im Falle eines Ausfalls der Energieversorgung der wenigstens eine Transportkörper unter Verwendung von Energie aus dem Energiespeicher bzw. der Energiespeicher kontrolliert derart auf den Stator aufgesetzt wird, dass er sich nicht mehr weiterbewegt, wenn die Stellelemente in einen stromlosen Zustand übergehen. Der wenigstens eine Transportkörper wird vorzugsweise auf die Beförderungsfläche aufgesetzt.

Es kann vorgesehen sein, dass die Stellelemente unter Verwendung von Energie aus dem Energiespeicher des Stators von der Stromzufuhr getrennt werden, wenn der wenigstens eine Transportkörper auf dem Stator aufsitzt. Die Unterbrechung der Stromversorgung der Stellelemente geschieht damit auf kontrollierte Weise. Unbeabsichtigte Bewegungen des wenigstens einen Transportkörpers werden mithin vermieden.

Es kann vorgesehen sein, dass nach einer Wiederherstellung der Energieversorgung von außen her die Stellelemente so lange stromlos bleiben, bis die Beförderungsvorrichtung wieder in der Lage ist, den wenigstens einen Transportkörper in kontrollierter Weise relativ zum Stator zu befördern, wobei die Stellelemente anschließend so mit Strom beaufschlagt werden, dass der wenigstens eine Transportkörper vom Stator abhebt. Der wenigstens eine Transportkörper hebt dabei vorzugsweise senkrecht zum Stator ab. Vorzugsweise wird eine Bestätigung des Benutzers eingeholt, ehe die Stellelemente mit Strom beaufschlagt werden. Dies geschieht beispielsweise über einen Taster oder einen Touchscreen.

Gemäß der Erfindung, werden die Stellelemente auf eine Fehlfunktion überwacht, wobei ein Stellelement, welches eine Fehlfunktion aufweist, nicht mehr angesteuert oder zeitlich konstant angesteuert wird, wobei ausschließlich dessen gemessene Stellung im Rahmen der kontrollierten Beförderung des wenigstens einen Transportkörpers berücksichtigt wird. Die genannte konstante Ansteuerung kann im fehlerfreien Betrieb wahlweise eine konstante Stellung des Stellelements oder eine konstante Verstellgeschwindigkeit des Stellelements zur Folge haben. Es versteht sich, dass im Falle einer Fehlfunktion nicht vorhersehbar ist, wie sich das Stellelement bei einer konstanten Ansteuerung bewegt. Die Überwachung auf eine Fehlfunktion geschieht beispielsweise dadurch, dass die vorgesehene SollStellung eines Stellelements mit einer, beispielsweise durch einen Drehgeber, gemessenen Ist-Stellung verglichen wird. Wenn die entsprechende Differenz einen vorgegebenen Grenzwert übersteigt, liegt eine Fehlfunktion vor.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung wird im Folgenden anhand der beigefügten Zeichnungen näher erläutert. Es zeigt:
- Fig. 1: eine grobschematische Schnittansicht einer erfindungsgemäßen Beförderungsvorrichtung.

Fig. 1 zeigt eine grobschematische Schnittansicht einer erfindungsgemäßen Beförderungsvorrichtung 10, die gemäß der deutschen Patentanmeldung mit dem Aktenzeichen 102016224951.7 aufgebaut ist. Der gesamte Inhalt der vorstehend genannten Patentanmeldung wird in Bezug genommen und zum Inhalt der vorliegenden Anmeldung gemacht.

Die Beförderungsvorrichtung 10 umfasst einen Stator 20 und wenigstens einen Transportkörper 50. Vorliegend sind drei Transportkörper 50 vorgesehen, wobei weitgehend beliebig viele Transportkörper 50 verwendbar sind. Der Stator 20 ist aus mehreren, vorzugsweise untereinander identischen Antriebsmodulen 36 zusammengesetzt, die in der Draufsicht vorzugsweise rechteckig, quadratisch oder sechseckig ausgebildet sind, damit sie spaltfrei in zwei Raumrichtungen X und Y aneinander angebaut werden können. Es versteht sich, dass auch nur ein einziges Antriebsmodul 36 vorgesehen sein kann. Die Antriebsmodule 36 bilden eine gemeinsame ebene, geschlossene Beförderungsfläche 23, wobei jedes Antriebsmodul 36 vorzugsweise eine gesonderte Deckplatte 32 aufweist, welche die Beförderungsfläche 23 bildet. Die Deckplatten 32 sind vorzugsweise als ebene Platten mit konstanter Dicke ausgebildet, welche mit dem verbleibenden Gehäuse eines Antriebsmoduls 36 fest verbunden, insbesondere verschraubt sind. Die Antriebsmodule 36 sind auf einer gemeinsamen Montageplattform 39 befestigt, welche beispielsweise als ebene Platte mit konstanter Dicke ausgebildet ist.

Im Inneren eines jeden Antriebsmoduls 36 sind mehrere Stellelemente 22 mit Stellmagneten 21 angeordnet, die vorzugsweise untereinander identisch ausgebildet sind. Das Stellelement 22 ist vorzugsweise als Elektromotor 24 ausgebildet, wobei es einen einzigen Bewegungsfreiheitsgrad hat, nämlich einen endlosen Drehfreiheitsgrad. Die Drehachsen 26 aller Stellelemente 22 sind senkrecht zur Beförderungsfläche 23 ausgerichtet, so dass die Stellelemente 22 mit den Stellmagneten 21 problemlos in einem 2-dimensionalen Raster nebeneinander anordenbar sind, wobei die Stellmagnete 21 sehr nahe an der Beförderungsfläche 23 angeordnet sind. Das genannte Raster ist vorzugsweise gleichförmig ausgebildet, wobei auch ungleichförmige Raster verwendbar sind. Der Abstand aller Stellmagnete 21 zur Beförderungsfläche 23 ist vorzugsweise identisch ausgebildet. Die Elektromotoren 24 sind vorzugsweise als bürstenlose Gleichstrommotoren ausgebildet, so dass sie im stromlosen Zustand kein Rastmoment aufweisen, wobei ihr Reibmoment ebenfalls sehr gering ist. Im stromlosen Zustand drehen sich die Elektromotoren 24 folglich selbsttätig in eine stabile Stellung, in der besonders große magnetische Anziehungskräfte zwischen den Stellmagneten 21 und den Transportkörpern 50 vorliegen. In der Folge werden die Transportkörper 50 im stromlosen Zustand an die Beförderungsfläche 23 angezogen und dort reibschlüssig gehalten, so dass sie sich nicht bewegen können bzw. nur unter hohem Kraftaufwand bewegbar sind.

Jeder Elektromotor 24 ist vorzugsweise mit einem Drehgeber ausgerüstet, so dass dessen Drehstellung messbar ist. Jedem Elektromotor 24 ist vorzugsweise ein gesonderter Drehlageregler zugeordnet, welcher Bestandteil der Steuerungseinheit 37 eines Antriebsmoduls 36 ist. Die Steuerungseinheit 37 ist vorliegend als elektrische Platine ausgebildet, welche unterhalb der Elektromotoren 24 angeordnet ist. Die Elektromotoren 24 können unmittelbar mit der Platine verlötet sein oder über Steckverbinder oder kurze Kabel mit dieser verbunden sein. Die Elektromotoren können beispielsweise 3-phasig ausgeführt sein, wobei jeder Phase eine H-Brücke zugeordnet sein kann, mit welcher der betreffende Strom einstellbar ist. Der genannte Drehlageregler vergleicht die gewünschte Soll-Drehlage des betreffenden Elektromotors 24 mit der durch den betreffenden Drehgeber gemessenen Ist-Drehlage und stellt die drei Motor-Ströme mittels der H-Brücken so ein, dass sich die Ist-Drehlage an die Soll-Drehlager annähert.

Das Gehäuse eines jeden Elektromotors 24 ist fest mit dem Gehäuse des zugeordneten Antriebsmoduls 36 verbunden, beispielswese verschraubt und/oder verlötet. Die Antriebswelle 25 eines jeden Elektromotors 24 ist fest mit einem zugeordneten Stellmagneten 21 verbunden. Alle Stellmagnete 21 sind vorzugsweise untereinander identisch ausgebildet. Sie sind beispielsweise aus drei würfel- bzw. quaderförmigen Einzelmagneten zusammengesetzt, die in einem gemeinsamen Halter aufgenommen sind, der beispielsweise aus Kunststoff besteht. Der Halter ist unmittelbar fest mit der Antriebswelle 25 verbunden. Die Einzelmagnete sind parallel zur Beförderungsfläche in einer Reihe etwas unterhalb der Beförderungsfläche 23 angeordnet. Ihr magnetisches Dipolmoment ist vorzugsweise jeweils parallel oder senkrecht zur Beförderungsfläche 23 ausgerichtet. Die genannten magnetischen Dipolmomente sind entsprechend einer Halbach-Anordnung ausgerichtet, so dass sich oberhalb der Beförderungsfläche 23 im Bereich der Transportkörper 50 ein besonders starkes Magnetfeld ergibt. Die Einzelmagnete sind vorzugsweise Permanentmagnete, die höchst vorzugsweise als Neodym-Eisen-Bor-Magnete ausgebildet sind. Die Einzelmagnete haben vorzugsweise jeweils ein Magnetfeld, das in einigem Abstand mit guter Näherung demjenigen eines idealen magnetischen Dipols entspricht. Es versteht sich, dass die Stellmagnete 21 auch jeweils einstückig ausgebildet sein können, wobei sie, wie vorstehend beschrieben, magnetisiert sind.

Hinzuweisen ist noch auf die optionale Kühlungseinheit 38, welche vorliegend unterhalb der Elektromotoren 24 und der Steuereinheit 37 angeordnet ist. Insbesondere in den oben genannten Elektromotoren entsteht Verlustwärme, welche mittels der Kühlungseinheit 38 abführbar ist. Die Kühlungseinheit 38 kann in Form einer Flüssigkeitskühlung ausgebildet sein, wobei vorzugsweise eine Luftkühlung, beispielsweise mit aktiven Lüftern, vorgesehen ist.

Die Transportkörper 50 haben vorzugsweise an ihrer der Beförderungsfläche 23 zugewandten Unterseite eine ebene Bodenfläche 52, die während des Betriebs der Beförderungsvorrichtung 10 meistens mit Abstand parallel zur Beförderungsfläche 23 angeordnet ist, wobei der Transportkörper 50 dort allein durch Magnetkräfte in der Schwebe gehalten wird. Der Transportkörper 50 ist vorliegend in Form einer ebenen Platte mit konstanter Dicke ausgebildet, welche in der Draufsicht beispielsweise einen rechteckigen, einen quadratischen oder einen kreisförmigen Umriss aufweist. Hierbei handelt es sich um eine für einen Werkstückträger typische Form, wobei der Transportkörper 50 weitgehend beliebig geformt sein kann. Der Transportkörper 50 trägt vorliegend eine Nutzlast 70.

Im Bereich der Bodenfläche 52 und mit geringem Abstand zu dieser sind mehrere Stationärmagnete 51 ortsfest im Transportkörper 50 aufgenommen. Diese sind ebenfalls als Permanentmagnete ausgeführt, wobei es sich vorzugsweise um Eisen-Bor-Neodym-Magnete handelt. Jeder einzelne Stationärmagnet 51 hat vorzugsweise ein Magnetfeld, welches zumindest in einigem Abstand mit guter Näherung dem Magnetfeld eines idealen magnetischen Dipols entspricht. Die Stationärmagnete 51 sind verteilt über die gesamte Bodenfläche 52 des Transportkörpers 50 angeordnet. Die genaue Verteilung der Stationärmagnete 51 ist eher zweitrangig. Vorrangig ist, dass ihre genaue Position und Ausrichtung am Transportkörper 50 bekannt ist, so dass diese im Rahmen der Berechnung der Magnetkräfte verwendet werden kann. Damit ist es ohne weiteres möglich, das Gesamtmagnetfeld eines Transportkörpers 50 zu berechnen. Die magnetischen Dipolmomente der Stationärmagnete 51 sind vorzugsweise senkrecht oder parallel zur Bodenfläche 52 ausgerichtet. Die magnetischen Dipolmomente sind in der Art eines Halbach-Arrays ausgerichtet, so dass sich unterhalb der Bodenfläche 52 ein besonders starkes Magnetfeld ergibt.

Die Beförderungsvorrichtung 10 ist weiter mit einer Positionsbestimmungseinheit 11 ausgestattet, die beispielsweise gemäß der US 6 615 155 B2 ausgebildet sein kann. Mit einer derartigen Positionsbestimmungseinheit 11 ist es möglich, die Position eines jeden Transportkörpers 50 relativ zum Stator 20 zu bestimmen und zwar jeweils in sechs Freiheitsgraden. Diese Positionsbestimmungseinheit 11 arbeitet vorliegend induktiv. Das Statorteil 33 der Positionsbestimmungseinheit 11 umfasst eine Vielzahl von planaren Sendespulen, die mit geringem Abstand zur Beförderungsfläche 23 und parallel zu dieser angeordnet sind. Die Sendespulen sind in einem 2-dimensionalen Raster verteilt über die gesamten Beförderungsfläche 23 angeordnet. Sie sind so klein ausgebildet, dass im Bereich eines Transportkörpers 50 wenigstens drei, vorzugsweise noch mehr Sendespulen angeordnet sind. Das bewegliche Teil 69 der Positionsbestimmungseinheit 11 umfasst mehrere Empfängerspulen, vorzugsweise wenigstens drei Empfängerspulen, die am Transportkörper 50 fest angeordnet sind.

Die Senderspulen werden nacheinander mit Wechselstrom beaufschlagt, welcher in den Empfängerspulen eine Spannung induziert. Aus den Wechselströmen und den induzierten Spannungen kann die Position eines Transportkörpers 50 relativ zum Stator 20 berechnet werden. Die Messung der induzierten Spannung wird von einer Steuerungseinheit 68 im Transportkörper 50 vorgenommen, welche vorzugsweise von einem dortigen elektrischen Energiespeicher 66 mit Energie versorgt wird. Zwischen den Steuerungseinheiten 68 in den Transportkörpern 50 und den Steuerungseinheiten 37 in den Antriebsmodulen 36 besteht vorzugsweise eine drahtlose Datenaustauschverbindung 43, damit die für die Positionsbestimmung erforderlichen Messwerte zusammengeführt werden können und der Transportkörper eine digitale Identifikationsnummer zum Stator übertragen kann. Die Position eines Transportkörpers 50 wird vorzugsweise bezüglich eines Koordinatensystems 31 ermittelt, dessen Achsen senkrecht bzw. parallel zur Beförderungsfläche 23 ausgerichtet sind. Hinzuweisen ist außerdem auf die Datenschnittstellen 42 zwischen benachbarten Antriebsmodulen 36 und der Datenschnittstelle 41 nach außen.

Aus der Position eines Transportkörpers relativ zum Stator und den Ist-Drehstellungen der Elektromotoren 24 kann die Magnetkraft berechnet werden, welche die Stellmagnete auf die Stationärmagnete ausüben, wobei vorzugsweise die Formeln für die Kraft und das Drehmoment zwischen zwei magnetischen Dipolen zum Einsatz kommen, welche unter der Internetadresse https://de.wikipedia.org/w/index.php?title=Magnetisches_Dipolmoment abrufbar sind. Durch Lösung eines entsprechenden nichtlinearen Gleichungssystems lässt sich umgekehrt auch berechnen, welche Soll-Drehlagen die Elektromotoren 24 einnehmen müssen, damit auf einen Transportkörper 50 eine gewünschte Magnetkraft und ein gewünschtes Magnetdrehmoment einwirken. Damit dieses Gleichungssystem sicher lösbar ist, sind vorzugsweise wenigstens sechs, höchst vorzugsweise wenigstens neun Stellmagnete unmittelbar unterhalb eines Transportkörpers angeordnet.

Die genannte Magnetkraft und das genannte Magnetdrehmoment sind vorzugsweise die Stellgrößen einer 6-dimensionalen-Positionsregelung eines Transportkörpers 50, welche beispielsweise unter Verwendung von PID-Reglern durchgeführt wird. Damit ist es möglich, einen Transportkörper 50 in kontrollierter Weise relativ zum Stator 20 zu bewegen, indem der Positionsregelung entsprechende Soll-Positionen des Transportkörpers 50 vorgegeben werden. Die Positionsregelung ist dabei insbesondere in der Lage, die Transportkörper 50 allein durch Magnetkräfte in der Schwebe zu halten, wobei sich weitgehend jede beliebige Position der Transportkörper 50 einstellen lässt. Vorzugsweise ist die Bodenfläche 52 in etwa parallel und mit geringem Abstand zur Beförderungsfläche 23 angeordnet, damit sich starke Magnetkräfte ergeben. Die Magnetkräfte sind dabei so stark, dass es ohne weiteres möglich ist, die Beförderungsfläche 23 in jeder beliebigen Richtung relativ zur Schwerkraft auszurichten. Auch wenn der Stator 20 bezüglich der Schwerkraft oberhalb oder neben den Transportkörpern 50 angeordnet ist, können die Transportkörper 50 in der Schwebe gehalten werden. In der Folge ist es auch nicht zwingend erforderlich, die Beförderungsfläche 23 eben auszuführen, diese kann vielmehr einen beliebig im Raum gekrümmten Verlauf haben. Die entsprechenden Krümmungsradien sind vorzugsweise so groß gewählt, dass die Transportkörper 50 der Beförderungsfläche 23 mit einem Abstand folgen können, der die Einstellung von Magnetkräften ermöglicht, die genügend groß sind, um die Transportkörper 50 in der Schwebe zu halten.

### Bezugszeichen

- 10: Beförderungsvorrichtung
- 11: Positionsbestimmungseinheit

- 20: Stator
- 21: Stellmagnet
- 22: Stellelement
- 23: Beförderungsfläche
- 24: Elektromotor
- 25: Antriebswelle des Elektromotors
- 26: Drehachse des Stellelements
- 27: Energieversorgung von außen her
- 28: Energiespeicher des Stators

- 31: Koordinatensystem
- 32: Deckplatte des Stators
- 33: Statorteil der Positionsbestimmungseinheit
- 36: Antriebsmodul des Stators
- 37: Steuerungseinheit Antriebsmodul
- 38: Kühlungseinheit Antriebsmodul
- 39: Montageplattform Antriebsmodule
- 41: Datenschnittstelle nach außen
- 42: Datenschnittstelle zum Nachbarmodul
- 43: drahtlose Datenaustauschverbindung

- 50: Transportkörper
- 51: Stationärmagnet
- 52: Bodenfläche des Transportkörpers
- 66: Energiespeicher eines Transportkörpers
- 68: Steuerungseinheit des Transportkörpers
- 69: bewegliches Teil der Positionsbestimmungseinheit
- 70: Nutzlast

## Patentansprüche

1. Beförderungsvorrichtung (10) mit einem Stator (20) und wenigstens einem Transportkörper (50), wobei die Beförderungsvorrichtung (10) dazu eingerichtet ist, den wenigstens einen Transportkörper (50) in kontrollierter Weise relativ zum Stator (20) zu befördern, wobei:
- der Stator (20) mehrere beweglich angeordnete, als Permanentmagneten ausgeführte, Stellmagneten (21) aufweist, von denen jeder über jeweils ein Stellelement (22) mit dem Stator (20) verbunden ist, das dazu eingerichtet ist, eine Position und/oder eine Orientierung des damit verbundenen Stellmagneten (21) relativ zum Stator (20) in kontrollierter Weise zu ändern;
- der wenigstens eine Transportkörper (50) wenigstens zwei, als Permanentmagneten ausgeführte, Stationärmagneten (51) aufweist, welche mit dem Transportkörper (50) derart verbunden sind, dass die wenigstens zwei Stationärmagneten (51) relativ zum Transportkörper (50) unbeweglich sind;
- der Stator (20) und der wenigstens eine Transportkörper (50) mittels der wenigstens zwei Stationärmagneten (51) und der mehreren Stellmagneten (21) magnetisch gekoppelt sind,
wobei der Transportkörper (50) allein durch permanentmagnetische Kräfte der Stellmagneten und der Stationärmagneten in der Schwebe haltbar ist, wobei die Position des Transportkörpers relativ zum Stator in sechs Freiheitsgraden verstellbar ist; und
- die Stellelemente (22) mittels elektrischen Stroms verstellbar sind, wobei eine Rast- und/oder eine Reibkraft jedes der Stellelemente (22) im stromlosen Zustand so klein gewählt ist, dass sich das Stellelement (22) im stromlosen Zustand unter dem Einfluss der magnetischen Kopplung zwischen den Stationärmagneten (51) und den Stellmagneten (21) selbsttätig in eine stabile Stellung bewegt.

2. Beförderungsvorrichtung (10) mit einem Stator (20) und zumindest einem Transportkörper (50), wobei die Beförderungsvorrichtung dazu eingerichtet ist, den zumindest einen Transportkörper in kontrollierter Weise relativ zum Stator zu befördern, wobei:
- der zumindest eine Transportkörper mehrere beweglich angeordnete, als Permanentmagneten ausgeführte, Stellmagneten (21) aufweist, von denen jeder über jeweils ein Stellelement (22) mit dem Transportkörper verbunden ist, das dazu eingerichtet ist, eine Position und/oder eine Orientierung des damit verbundenen Stellmagneten relativ zum Transportkörper in kontrollierter Weise zu ändern;
- der Stator zumindest zwei, als Permanentmagneten ausgeführte, Stationärmagneten (51) aufweist, welche mit dem Stator derart verbunden sind, dass die zumindest zwei Stationärmagneten relativ zum Stator unbeweglich sind;
- der zumindest eine Transportkörper und der Stator mittels der zumindest zwei Stationärmagneten und der mehreren Stellmagneten magnetisch gekoppelt sind,
wobei der Transportkörper (50) allein durch permanentmagnetische Kräfte der Stellmagneten und der Stationärmagneten in der Schwebe haltbar ist, wobei die Position des Transportkörpers relativ zum Stator in sechs Freiheitsgraden verstellbar ist; und
- die Stellelemente (22) mittels elektrischen Stroms verstellbar sind, wobei eine Rast- und/oder eine Reibkraft jedes der Stellelemente im stromlosen Zustand so klein gewählt ist, dass sich das Stellelement im stromlosen Zustand unter dem Einfluss der magnetischen Kopplung zwischen den Stationärmagneten und den Stellmagneten selbsttätig in eine stabile Stellung bewegt.

3. Beförderungsvorrichtung nach einem der vorstehenden Ansprüche,
wobei das Stellelement (22) einen Elektromotor (24) umfasst, welcher als Synchronmotor mit einem permanentmagnetischen Läufer oder als Asynchronmotor mit einem Kurzschlussläufer ausgebildet ist.

4. Beförderungsvorrichtung nach Anspruch 3,
wobei eine Antriebswelle (25) des Elektromotors (24) fest mit dem zugeordneten Stellmagneten (21) verbunden ist.

5. Beförderungsvorrichtung nach einem der vorstehenden Ansprüche,
wobei der wenigstens eine Transportkörper (50) und/oder der Stator (20) jeweils einen Energiespeicher (28; 66) aufweist, wobei die Beförderungsvorrichtung (10) eine äußere Energieversorgung (27) aufweist und so eingerichtet ist, dass sie die für einen Weiterbetrieb erforderliche Energie aus dem Energiespeicher bzw. den Energiespeichern (28; 66) entnimmt, wenn die Energieversorgung (27) von außen her ausfällt.

6. Beförderungsvorrichtung nach einem der vorstehenden Ansprüche,
wobei der Stator (20) eine geschlossene Beförderungsfläche (23) aufweist, welche zwischen den Stellmagneten (21) und dem wenigstens einen Transportkörper (50) angeordnet ist.

7. Beförderungsvorrichtung nach einem der vorstehenden Ansprüche,
wobei die Beförderungsvorrichtung (10) dazu eingerichtet ist, den zumindest einen Transportkörper (50) durch eine kontrollierte Positionierung und/oder Orientierung der mehreren Stellmagneten (21) mittels der Stellelemente (22) relativ zum Stator (100) zu befördern.

8. Verfahren zum Betrieb einer Beförderungsvorrichtung nach einem der Ansprüche 1 bis 7, **dadurch gekennzeichnet, dass**
die Stellelemente (22) auf eine Fehlfunktion überwacht werden, wobei ein Stellelement (22), welches eine Fehlfunktion aufweist, nicht mehr angesteuert oder zeitlich konstant angesteuert wird, wobei ausschließlich dessen gemessene Stellung im Rahmen einer kontrollierten Beförderung des wenigstens einen Transportkörpers (50) berücksichtigt wird.

9. Verfahren zum Betrieb einer Beförderungsvorrichtung nach Anspruch 8, wenn abhängig von Anspruch 5,
wobei die Energieversorgung (27) von außen her auf einen Ausfall hin überwacht wird, wobei im Falle eines Ausfalls der Energieversorgung (27) der wenigstens eine Transportkörper (50) unter Verwendung von Energie aus dem Energiespeicher bzw. der Energiespeicher (28; 66) kontrolliert derart auf den Stator (20) aufgesetzt wird, dass er sich nicht mehr weiterbewegt, wenn die Stellelemente (22) in einen stromlosen Zustand übergehen.

10. Verfahren nach Anspruch 9,
wobei die Stellelemente (22) unter Verwendung von Energie aus dem Energiespeicher (28) des Stators (20) von einer Stromzufuhr getrennt werden, wenn der wenigstens eine Transportkörper (50) auf dem Stator (20) aufsitzt, so dass eine Unterbrechung der Energieversorgung der Stellelemente damit auf kontrollierte Weise geschieht und unbeabsichtigte Bewegungen des wenigstens einen Transportkörpers mithin vermieden werden.

11. Verfahren nach Anspruch 9 oder 10,
wobei nach einer Wiederherstellung der Energieversorgung (27) von außen her die Stellelemente (22) so lange stromlos bleiben, bis die Beförderungsvorrichtung (10) wieder in der Lage ist, den wenigstens einen Transportkörper (50) in kontrollierter Weise relativ zum Stator (20) zu befördern, wobei die Stellelemente (22) anschließend so mit Strom beaufschlagt werden, dass der wenigstens eine Transportkörper (50) vom Stator (20) abhebt.

## Claims

1. Conveying apparatus (10) comprising a stator (20) and at least one transportation body (50), wherein the conveying apparatus (10) is designed to convey the at least one transportation body (50) relative to the stator (20) in a controlled manner, wherein:
- the stator (20) has a plurality of actuating magnets (21) which are arranged in a movable manner and which are embodied as permanent magnets and each of which is connected to the stator (20) by means of a respective actuating element (22) which is designed to change a position and/or an orientation of the actuating magnet (21) associated with it relative to the stator (20) in a controlled manner;
- the at least one transportation body (50) has at least two stationary magnets (51) which are embodied as permanent magnets and which are connected to the transportation body (50) in such a way that the at least two stationary magnets (51) are immovable relative to the transportation body (50);
- the stator (20) and the at least one transportation body (50) are magnetically coupled by means of the at least two stationary magnets (51) and the plurality of actuating magnets (21),
wherein
the transportation body (50) can be held in a floating manner solely by permanent-magnet forces of the actuating magnets and of the stationary magnets, wherein the position of the transportation body relative to the stator can be adjusted in six degrees of freedom; and
- the actuating elements (22) can be adjusted by means of electric current, wherein a latching force and/or a friction force of each of the actuating elements (22) in the deenergized state is selected to be so low that the actuating element (22) is automatically moved to a stable position under the influence of the magnetic coupling between the stationary magnets (51) and the actuating magnets (21) in the deenergized state.

2. Conveying apparatus (10) comprising a stator (20) and at least one transportation body (50), wherein the conveying apparatus is designed to convey the at least one transportation body relative to the stator in a controlled manner, wherein:
- the at least one transportation body has a plurality of actuating magnets (21) which are arranged in a movable manner and which are embodied as permanent magnets and each of which is connected to the transportation body by means of a respective actuating element (22) which is designed to change a position and/or an orientation of the actuating magnet associated with it relative to the transportation body in a controlled manner;
- the stator has at least two stationary magnets (51) which are embodied as permanent magnets and which are connected to the stator in such a way that the at least two stationary magnets are immovable relative to the stator;
- the at least one transportation body and the stator are magnetically coupled by means of the at least two stationary magnets and the plurality of actuating magnets,
wherein
the transportation body (50) can be held in a floating manner solely by permanent-magnet forces of the actuating magnets and of the stationary magnets, wherein the position of the transportation body relative to the stator can be adjusted in six degrees of freedom; and
- the actuating elements (22) can be adjusted by means of electric current, wherein a latching force and/or a friction force of each of the actuating elements in the deenergized state is selected to be so low that the actuating element is automatically moved to a stable position under the influence of the magnetic coupling between the stationary magnets and the actuating magnets in the deenergized state.

3. Conveying apparatus according to either of the preceding claims,
wherein the actuating element (22) comprises an electric motor (24) which is designed as a synchronous motor with a permanent-magnet rotor or as an asynchronous motor with a squirrel-cage rotor.

4. Conveying apparatus according to Claim 3,
wherein a drive shaft (25) of the electric motor (24) is fixedly connected to the associated actuating magnet (21) .

5. Conveying apparatus according to one of the preceding claims,
wherein the at least one transportation body (50) and/or the stator (20) have/has a respective energy store (28; 66), wherein the conveying apparatus (10) has an external energy supply (27) and is designed such that it draws the energy required for further operation from the energy store or the energy stores (28; 66) if the energy supply (27) from the outside fails.

6. Conveying apparatus according to one of the preceding claims,
wherein the stator (20) has a closed conveying surface (23) which is arranged between the actuating magnets (21) and the at least one transportation body (50).

7. Conveying apparatus according to one of the preceding claims,
wherein the conveying apparatus (10) is designed to convey the at least one transportation body (50) relative to the stator (100) by controlled positioning and/or orientation of the plurality of actuating magnets (21) by means of the actuating elements (22).

8. Method for operating a conveying apparatus according to one of Claims 1 to 7, **characterized in that**
the actuating elements (22) are monitored for a malfunction, wherein an actuating element (22) which exhibits a malfunction is no longer actuated or is actuated in a constant manner over time, wherein only the measured position of the said actuating element is taken into account in the course of controlled conveying of the at least one transportation body (50).

9. Method for operating a conveying device according to Claim 8, if dependent on Claim 5,
wherein the energy supply (27) from the outside is monitored for failure, wherein, in the case of failure of the energy supply (27), the at least one transportation body (50) is placed onto the stator (20) in a controlled manner using energy from the energy store or the energy stores (28; 66) in such a way that it no longer continues to move when the actuating elements (22) enter a deenergized state.

10. Method according to Claim 9,
wherein the actuating elements (22) are disconnected from a power supply using energy from the energy store (28) of the stator (20) when the at least one transportation body (50) sits on the stator (20), so that the energy supply to the actuating elements is interrupted in a controlled manner in this way and unintentional movements of the at least one transportation body are consequently avoided.

11. Method according to Claim 9 or 10,
wherein, after the energy supply (27) from the outside has been re-established, the actuating elements (22) remain deenergized until the conveying apparatus (10) is again able to convey the at least one transportation body (50) relative to the stator (20) in a controlled manner, wherein current is then applied to the actuating elements (22) such that the at least one transportation body (50) lifts away from the stator (20).

## Revendications

1. Dispositif de transport (10), comprenant un stator (20) et au moins un corps de transport (50), le dispositif de transport (10) étant aménagé pour transporter ledit au moins un corps de transport (50) de manière contrôlée par rapport au stator (20), dans lequel :
- le stator (20) présente plusieurs électroaimants de commande (21), disposés de manière mobile et réalisés sous forme d'aimants permanents, dont chacun est relié au stator (20) par un élément de réglage (22) respectif qui est aménagé pour modifier de manière contrôlée une position et/ou une orientation de l'électroaimant de commande (21) associé à celui-ci par rapport au stator (20) ;
- ledit au moins un corps de transport (50) présente au moins deux aimants stationnaires (51), réalisés sous forme d'aimants permanents, qui sont reliés au corps de transport (50) de telle sorte que les au moins deux aimants stationnaires (51) sont immobiles par rapport au corps de transport (50) ;
- le stator (20) et ledit au moins un corps de transport (50) sont couplés magnétiquement au moyen des au moins deux aimants stationnaires (51) et des plusieurs électroaimants de commande (21),
dans lequel
le corps de transport (50) peut être maintenu en suspension uniquement par les forces magnétiques permanentes des électroaimants de commande et des aimants stationnaires, la position du corps de transport par rapport au stator étant réglable selon six degrés de liberté ; et
- les éléments de réglage (22) sont réglables au moyen d'un courant électrique, une force de retenue et/ou de frottement de chacun des éléments de réglage (22) à l'état hors tension étant sélectionnée pour être si faible qu'à l'état hors tension, l'élément de réglage (22) se déplace automatiquement dans une position stable, sous l'influence du couplage magnétique entre les aimants stationnaires (51) et les électroaimants de commande (21) .

2. Dispositif de transport (10), comprenant un stator (20) et au moins un corps de transport (50), le dispositif de transport étant aménagé pour transporter ledit au moins un corps de transport de manière contrôlée par rapport au stator, dans lequel :
- ledit au moins un corps de transport présente plusieurs électroaimants de commande (21), disposés de manière mobile et réalisés sous forme d'aimants permanents, dont chacun est relié au corps de transport par un élément de réglage (22) respectivement qui est aménagé pour modifier de manière contrôlée une position et/ou une orientation de l'électroaimant de commande associé à celui-ci par rapport au corps de transport ;
- le stator présente au moins deux aimants stationnaires (51), réalisés sous forme d'aimants permanents, qui sont reliés au stator, de telle sorte que les moins deux aimants stationnaires sont immobiles par rapport au stator ;
- ledit au moins un corps de transport et le stator sont couplés magnétiquement au moyen des au moins deux aimants stationnaires et des plusieurs électroaimants de commande,
dans lequel
le corps de transport (50) peut être maintenu en suspension uniquement par les forces magnétiques permanentes des électroaimants de commande et des aimants stationnaires, la position du corps de transport par rapport au stator étant réglable selon six degrés de liberté ; et
- les éléments de réglage (22) sont réglables au moyen d'un courant électrique, une force de retenue et/ou de frottement de chacun des éléments de réglage à l'état hors tension étant sélectionnée pour être si faible qu'à l'état hors tension, l'élément de réglage se déplace automatiquement dans une position stable, sous l'influence du couplage magnétique entre les aimants stationnaires et les électroaimants de commande.

3. Dispositif de transport selon l'une quelconque des revendications précédentes, l'élément de réglage (22) comprenant un moteur électrique (24) qui est réalisé sous la forme d'un moteur synchrone doté d'un rotor à aimants permanents ou sous la forme d'un moteur asynchrone doté d'un rotor en court-circuit.

4. Dispositif de transport selon la revendication 3, dans lequel un arbre d'entraînement (25) du moteur électrique (24) est relié solidement à l'électroaimant de commande (21) associé.

5. Dispositif de transport selon l'une quelconque des revendications précédentes, dans lequel ledit au moins un corps de transport (50) et/ou le stator (20) présentent respectivement un accumulateur d'énergie (28 ; 66), le dispositif de transport (10) présentant une alimentation en énergie extérieure (27) et étant aménagé de telle sorte qu'il prélève l'énergie nécessaire au maintien du fonctionnement de l'accumulateur d'énergie ou des accumulateurs d'énergie (28 ; 66) si l'alimentation en énergie (27) venant de l'extérieur est défaillante.

6. Dispositif de transport selon l'une quelconque des revendications précédentes, dans lequel le stator (20) présente une surface de transport fermée (23) qui est disposée entre les électroaimants de commande (21) et ledit au moins un corps de transport (50).

7. Dispositif de transport selon l'une quelconque des revendications précédentes, le dispositif de transport (10) étant aménagé pour transporter ledit au moins un corps de transport (50) par un positionnement et/ou une orientation contrôlés des plusieurs électroaimants de commande (21) au moyen des éléments de réglage (22) par rapport au stator (100).

8. Procédé permettant de faire fonctionner un dispositif de transport selon l'une quelconque des revendications 1 à 7, **caractérisé en ce que** les éléments de réglage (22) sont surveillés quant à un dysfonctionnement, dans lequel un élément de réglage (22) présentant un dysfonctionnement n'est plus piloté ou est piloté de manière constante dans le temps, seule sa position mesurée étant prise en compte dans le cadre d'un transport contrôlé dudit au moins un corps de transport (50) .

9. Procédé permettant de faire fonctionner un appareil de transport selon la revendication 8 lorsqu'elle dépend de la revendication 5, dans lequel l'alimentation en énergie (27) venant de l'extérieur est surveillée quant à une défaillance, dans lequel, en cas de défaillance de l'alimentation en énergie (27), ledit au moins un corps de transport (50) est posé de manière contrôlée sur le stator (20) en utilisant de l'énergie provenant de l'accumulateur d'énergie ou des accumulateurs d'énergie (28 ; 66) de telle sorte qu'il ne se déplace plus lorsque les éléments de réglage (22) passent à un état hors tension.

10. Procédé selon la revendication 9, dans lequel les éléments de réglage (22) sont déconnectés d'une arrivée de courant en utilisant de l'énergie provenant de l'accumulateur d'énergie (28) du stator (20) lorsque ledit au moins un corps de transport (50) repose sur le stator (20) de sorte qu'une interruption de l'alimentation en énergie des éléments de réglage est ainsi effectuée de manière contrôlée et des mouvements involontaires dudit au moins un corps de transport sont donc évités.

11. Procédé selon la revendication 9 ou 10, dans lequel après un rétablissement de l'alimentation en énergie (27) venant de l'extérieur, les éléments de réglage (22) restent hors tension jusqu'à ce que le dispositif de transport (10) soit à nouveau en mesure de transporter ledit au moins un corps de transport (50) de manière contrôlée par rapport au stator (20), les éléments de réglage (22) étant ensuite sollicités par le courant de telle sorte que ledit au moins un corps de transport (50) décolle du stator (20).
